# EUROPEAN PATENT APPLICATION

(11) **EP 1 457 838 A1**
(43) Date of publication of application: **15.09.2004**
(21) Application number: 04075685.0
(22) Date of filing: 02.03.2004
(51) Int. Cl.: G03F 7/32, G03F 7/30

(54) **Method to reduce precipitation in developers for lithographic printing plates**

(30) Priority: 03.03.2003 EP 03075629
(71) Applicant: Fuji Photo Film B.V., 5047 TK Tilburg (NL)
(72) Inventor: Wiegers, Ronaldus Johannes Theodor H., 5237 NA 's-Hertogenbosch (NL); Sekiya, Toshiyuki, 5045 JW Tilburg (NL); Imaizumi, Mitsuhiro, 5045 JG Tilburg (NL)
(74) Representative: Winckels, Johannes Hubertus F.

(57) **Abstract**

The present invention provides a method for the development of lithographic printing plates in aqueous alkaline developer, characterized in that to said developer is added a surfactant during the preparation of the developer bath, or at the start of the usage of the developer. The method is particularly useful in prevention of undesired precipitates in automatic development machines that occur in commercially available developer solutions.

## Description

### Field of invention

The invention relates to the development of printing plates. More specifically, it relates to a method for the developing of lithographic printing plates, in particular presensitized lithographic printing plates (also known as "PS plates"), in aqueous developers.

### Background of the invention

The most common method of developing lithographic printing plates is the processing of such plates in an automatic development machine. Usually, these automatic development machines consist of a development section, a rinsing section, a finisher section and a dryer section. The development section is usually equipped with a circulation pump, a heating element, filters and the like, all meant to create a stable environment for the development of the printing plate.

One of the problems, which occur frequently, is the formation of precipitates in the development bath. These precipitates are problematic since they adhere to the plate and are not removed by the rinsing process, and thus can lead to undesired ink-acceptance in the subsequent printing process. The photosensitive layer of offset printing plates, by nature, contains large amounts of hydrophobic moieties, which are extracted from the plate during the development process. These substances, by nature, have in general a poor solubility in the aqueous developer, and can form precipitates. Especially in alkaline developers containing non-ionic surfactants, like the developer liquid described in EP-A-0 274 044, the poor solubility of photosensitive layer components can result in aggregation of surfactant molecules together with the hydrophobic moieties extracted from the plate and result in a large amount of precipitate. Especially when the automatic development machine is left to stand still for a considerable amount of time (e.g. during an overnight-stop or a weekend-stop) the precipitates will accumulate on the bottom of the developer tank.

Undesired aggregation of non-ionic surfactant can be prevented by addition of so-called hydrotropic surfactants, which enhance the solubility of surfactant molecules and aggregates in the developer, as mentioned in DE-A-19 755 131. However, these so called hydrotropes are not always present in commercially available developers, or the hydrotrope that is present does not tackle the problem of precipitation sufficiently. The latter is often the case when one wants to develop more than one type of plate in the same developer liquid.

Also other publications disclose the use of surfactants for developing PS plates. JP-A-22 62 148, for instance, discloses plates in which a surfactant is incorporated in the backing layer or the overcoating layer of the plate. According to this document an optimal surfactant concentration in the developing bath can thus be maintained during operation.

Furthermore, US-A-5 496 677 and US-A-6 436 596 describe developer solutions to which a surfactant has been added.

Although the above-mentioned processes may solve the problem of precipitation for a specific situation, in particular for specific combinations of type of PS plate and type of developer solution, it has been found that in practice serious precipitation problems often occur because the apparatuses used in the developing process is used for a multitude of different types of plates and solutions.

The need for preventing the formation of precipitates thus still remains.

### Summary of the invention

An object, therefore, of the invention is to provide a method by which lithographic printing plates can be developed in a commercially available developer without troublesome precipitation, even when undesired precipitation would occur in the developer bath when the developer is used as such. It is noted that according to the present inventors it has not been reported before that the problem of undesired precipitation occurs frequently in practice as a result of using different combinations of type of PS plate and type of developer solution. Thus a further object of the present invention may be formulated as to provide a more flexible process for developing PS plates.

A further object of the invention is to provide a method for the development of lithographic printing plates that makes it possible to develop different kinds of lithographic printing plates in a single developer liquid without the formation of precipitates.

A further object of the invention is to provide a method that enhances productivity in the preparation of lithographic printing plates, by changing a developer solution that is generating large amounts of precipitates, and thus reduces productivity by consuming large amounts of time for cleaning, into a developer that does not form these precipitates and thus yields a developing machine that is easy to clean.

The objects of the invention can be attained by a method for the development of lithographic printing plates in aqueous alkaline developer, characterized in that to said developer is added a surfactant during the preparation of the developer bath, or at the start of the usage of the developer.

The process according to the present invention is much more robust, in that it provides excellent results with a large number of combinations of type of plate and type of developer, in particular when using the preferred developers and surfactants mentioned hereinbelow.

### Detailed description of the preferred embodiments

The developers (as well as the replenishers for such developers) for which the invention is suitable are alkaline aqueous solutions, including alkaline aqueous solutions comprising an alkaline silicate or a nonreducing sugar, and a base, said solution's pH being preferably from 12.5 to 14.0. The alkaline silicate may be exhibiting an alkalinity when dissolved in water, and examples thereof include an alkali metal silicate such as sodium silicate, potassium silicate and lithium silicate, and ammonium silicate. Said alkaline silicate may be used alone, or in combination.

In the developer based on an alkaline aqueous solution comprising a nonreducing sugar and a base, the term "nonreducing sugar" denotes sugars having no reductive property due to the absence of a free aldehyde group or a free ketone group. Said nonreducing sugar is classified into trehalose-type oligosaccharides wherein a reductive group and another reductive group make a linkage; glycosides wherein a reductive group in a sugar is linked to a non-sugar compound; and sugar alcohols which are produced by reducing a sugar with hydrogenation. Said trehalose-type oligosaccharides include sucrose and trehalose, and said glycosides include alkyl glycosides, phenol glycosides, mustard oil glycosides and the like. Said sugar alcohols include D,L-arabitol, ribitol, xylitol, D,L-sorbitol, D,L-mannitol, D,L-iditol, talitol, dulcitol, allodulcitol and the like. Further, maltitol obtained by hydrogenation of disaccharide, a reduced material obtained by hydrogenation of oligosaccharide (a reduced starch syrup) and the like are preferably used. In the above nonreducing sugar, preferred are sugar alcohols and sucrose, and particularly preferred are D-sorbitol, sucrose and a reduced starch syrup, since they have buffering action in appropriate pH range.

The developers and the replenishers for which the invention is suitable may simultaneously contain other alkaline agents. Examples of such other alkaline agents include such inorganic alkaline agents as ammonium hydroxide, sodium tertiary phosphate, sodium secondary phosphate, potassium tertiary phosphate, potassium secondary phosphate, ammonium tertiary phosphate, ammonium secondary phosphate, sodium bicarbonate, sodium carbonate, potassium carbonate and ammonium carbonate; and such organic alkaline agents as mono-, di- or triethanolamine, mono-, di- or trimethylamine, mono-, di- or triethylamine, mono- or di- isopropylamine, n-butylamine, mono-, di- or triisopropanolamine, ethyleneimine, ethylenediimine and tetramethylammonium hydroxide.

Developers for which the invention is suitable include those comprising a nonionic surfactant carrying a polyoxyalkylene ether group. It is this surfactant that is often forming precipitates together with the hydrophobic moieties extracted from the plate during the development. The surfactant carrying a polyoxyalkylene ether group usually used herein is one having a structure represented by the following general formula (I): R-O-(R'-O)ₙH wherein R represents an alkyl group having 3 to 15 carbon atoms, which may have a substituent, an aromatic hydrocarbon group having 6 to 15 carbon atoms, which may be substituted with a substituent, or a aromatic heterocyclic group having 4 to 15 carbon atoms, which may have a substituent (in this respect, examples of substituents usable herein are alkyl groups each having 1 to 20 carbon atoms, halogen atoms such as Br, Cl and I, aromatic hydrocarbon groups each having 6 to 15 carbon atoms, aryl alkyl groups each having 7 to 17 carbon atoms, alkoxy groups each having 1 to 20 carbon atoms, alkoxycarbonyl groups each having 2 to 20 carbon atoms and acyl groups each having 2 to 15 carbon atoms), R' represents an alkylene group having 1 to 10 carbon atoms, which may have a substituent (wherein examples of substituents are alkyl groups each having 1 to 20 carbon atoms and aromatic hydrocarbon groups each having 6 to 15 carbon atoms) and n represents an integer ranging from 1 to 100.

Moreover, the moiety: (R'-O)ₙ of the compound of the formula (I) may comprise two or three different groups falling within the range specified above. Examples thereof are combinations such as ethyleneoxy and propyleneoxy groups; ethyleneoxy and isopropyloxy groups; ethyleneoxy and butyleneoxy groups; and ethyleneoxy and isobutyleneoxy groups, which are connected to one another in a random or block-like configuration.

These surfactants may be used alone or in any combination. In addition, the content of these surfactants in the developer preferably ranges from 0.1 to 20% by weight as expressed in terms of the amount of the effective component.

In addition to the foregoing components, the developers for which the invention is suitable may if necessary comprise various components listed below in combination. Examples thereof include organic carboxylic acids such as benzoic acid, phthalic acid, p-ethylbenzoic acid, p-n-propylbenzoic acid, p-isopropylbenzoic acid, p-n-butylbenzoic acid, p-t-butylbenzoic acid, p-2-hydroxyethylbenzoic acid, decanoic acid, salicylic acid and 3-hydroxy-2-naphthoic acid; organic solvents such as isopropyl alcohol, benzyl alcohol, ethyl cellosolve, butyl cellosolve, phenyl cellosolve, phenyl cellosolve, propylene glycol and diacetone alcohol; and other components such as chelating agents, reducing agents, dyes, pigments, water softeners, preservatives and antifoamers.

To the developer for which the invention is suitable, according to the present invention, separately a surfactant or a mixture of surfactants is added. The surfactant is typically added by pouring the surfactant liquid or a solution thereof in the developer bath or by dissolving a solid surfactant in the developer bath, by adding it in solid form to said bath. It is preferred to homogenize the developer/surfactant solution, so that concentration gradients in the developer bath are avoided as much as possible. Thus, addition of surfactant is preferably not carried out by incorporating the surfactant in the backing layer or the overcoating layer of the plate. The addition of this surfactant should be done when the developer bath is being prepared in the automatic development machine, either before filling up the automatic development machine *(i.e.* after opening of the can or barrel that contains the developer liquid) with developer liquid, or during the filling of the automatic development machine or after completion of the filling of the automatic development machine, but not after a substantial amount of plates have been developed. In case of developers that request dilution with water before usage, the surfactant can be added in any stage of the preparation of the developer bath (after opening of the can or barrel that contains the developer liquid, during the stage of dilution, or filling up of the developer machine, or after the filling up of the development machine is completed).

Preferably, not more than one square meter of plate per litre developer should be developed before addition of the surfactant. More preferably, not more than 0.2 square meter of plate per litre developer should be developed before addition of the surfactant, most preferably 0 or less than 0.02 square meter of plate per litre developer should be developed before addition of the surfactant. When the addition is done later, the aggregates of non-ionic surfactant from the developer and the hydrophobic moieties extracted from the plate have been formed and cannot be re-dispersed.

Most processors which are used in the art are usually equipped with filters in the development section, through which developer liquid from the developer bath is circulated. The purpose of these filters is to filter out precipitate that is floating in the developer liquid, thus reducing the amount of spots deposited on the plates. According another embodiment of the present invention, another means of supplying the surfactant to the developer bath composition at the start of usage of the developer bath, is to make use of specially prepared filters, onto which the surfactant has been absorbed. These filters can be prepared by soaking the filters in aqueous solutions of the desired surfactant, optionally drying these filters, and placing them in the already available filter holders of the automatic development machine during the preparation of the developer bath.

The surfactants useful for the present invention have the property that they can stabilize the non-ionic surfactant in the developer liquid, thus preventing unwanted precipitation. These surfactants can be anionic, cationic or non-ionic by nature. Specific examples of the anionic surfactants to be used in the present invention include ethylhexylsulfosuccinic acid, (alkyl)arylsulfonic acids such as benzenesulfonic acid, p-toluenesulfonic acid, xylenesulfonic acid, cumensulfonic acid, phenolsulfonic acid isop hthalylsulfonic acid, 4-(butylphenyl)-2-hydroxybenzenesulfonic acid, 4-(butylphenyl)benzenesulfonic acid, alkyldiphenylethersulfonic acids; arylcarboxylic acids such as benzoic acid, salicylic acid, gallic acid, thiosalicylic acid. Specific examples of the cationic surfactants to be used in the present invention include tetraphenylphosphonium iodide, tetraphenylphosphonium bromide, tetraphenylphosphonium chloride, tetraphenylphosphonium sulfate, tetraphenylphosphonium nitrate, sodium tetraphenylborate, tetra-n-butylphosphonium iodide, tetra-n-butylphosphonium bromide, tetra-n-butylphosphonium chloride, tetra-n-butylphosphonium sulfate, tetra-n-butylphosphonium nitrate, tetrabutylammonium sulfate, tetrabutylammonium nitrate, ethyltriphenylphosphonium bromide, benzyltriphenylphosphonium chloride, tetrabutylphosphonium hydroxide, tetrabutylphosphonium phosphate, ethyltriphenylphosphonium bromide, butyltriphenylphosphonium bromide, diphenylphosphonium chloride, benzyltriphenylphosphonium chloride, tetratollylphosphonium bromide, bis[(benzyl)(diphenyl)phosphorandiyl]ammonium chloride, 1,2-bis(diphenylphosphino)ethanebromide. Further, alkaline metal (e.g., Na, K, Li) salts, ammonium salts, butylisoquinoliniumbromides and methylisoquinoliniumchlorides of these compounds may be used

Specific examples of non-ionic surfactants useful in the present invention are alkyl polyethylene oxides (such as dodecyl-polyethylene oxide, octyl polyethylene oxide); (alkyl)-aryl-polyethylene oxides, tall oil ethoxylates, fatty acid esters with polyhydric alcohols such as sorbitan monooleate, sorbitan monopalmitate and alkylpolyglucosides.

Particularly preferred examples of the hydrotrope agent employable in the present invention include alkyldiphenylethersulfonic acids or alkali salts, sodium p-toluenesulfonate, sodium methaxylenesulfonate, sodium p-ethylbenzenesulfonate, sodium cumensulfonate, sodium naphthalenesulfonate, ammonium xylenesulfonate, tetrabutylammonium bromide, sorbitan monooleate and tall oil ethoxylate. Preferred among these compounds are sodium dodecyldiphenylethersulfonate, sodium methaxylenesulfonate, sodium naphthalene-sulfonate, sorbitan monooleate and tall oil ethoxylate. The present invention is not limited to these compounds: the type of surfactant is amongst others depending on the type of non-ionic surfactant in the developer, on the type of hydrophobic moieties extracted from the plate during development, and on the further composition of the developer liquid.

The final concentration of hydrotrope agent in the developer solution after addition is preferably in the range of 0.0005 to 2 % by weight, more preferably 0.01 to 0.5 % by weight.

The surfactant can be added as a single substance, or as a mixture of various surfactants. It can be added as a pure substance, or as a solution in an appropriate solvent. The surfactant of the present invention can be mixed with various additives, including but not limited to pH-regulators, chelating agents, reducing agents, dyes, pigments, water softeners, preservatives and antifoamers

The present invention can be applied for the development of various types of plates, including but not limited to conventional positive lithographic printing plates (comprising o-diazonaphthoquinone-based resins and novolak resins), certain types of conventional negative lithographic printing plates, thermal positive lithographic printing plates, thermal negative lithographic printing plates.

### Examples

The present invention will be explained in detail by the following non-limiting examples.

### Comparative Example 1

An automatic development machine (Fujifilm FLH-85N) is filled with 50 litre of developer (Fujifilm HD-P2). Twenty sheets of thermal PS-plate (Fujifilm LH-PSE) totalling 16 m² are fed through this machine. About 50% of the total area is exposed by IR radiation. The developer machine is then shut down for 64 hrs, after which the machine is restarted by feeding another 10 sheets (8 m²). These sheets show a large amount of spots on the plate. After emptying the automatic development machine, it is observed that it contains quite large amounts of precipitate.

### Comparative Example 2

An automatic development machine (Fujifilm FLH-85N) is filled with 30 litre of developer (Fujifilm HD-P2). Twenty sheets of thermal PS-plate (Fujifilm LH-PSE) totalling 16 m² are fed through this machine. About 50% of the total area is exposed by IR radiation. From the 4^{th} sheet onwards, the plates show an increasing amount on spots on the plate. When the developer bath is emptied, a fair amount of precipitate is found on the bottom of the development tank.

### Example 3

An automatic development machine (Fujifilm FLH-85N) is filled with 30 litre of developer (Fujifilm HD-P2). To this bath, 40 cc of a 10% solution of sodium dodecyldiphenylethersulfonate is added. Twenty sheets of thermal PS-plate (Fujifilm LH-PSE), totalling 16 m² are fed through this machine. About 50% of the total area is exposed by IR radiation. The developer machine is then shut down for 64 hrs, after which the machine is restarted by feeding another 10 sheets (8 m²). The plates do not show spots, and, upon emptying it, the automatic development machine is free from any precipitate.

### Example 4

Two filters (10 um polypropylene filter) are soaked in a 5% aqueous solution of sodium dodecyldiphenylethersulfonate. After soaking, the filters are dried at 40°C until they are dry. The filters are then installed in the developer filter section of an automatic development machine (Fujifilm FLH-85N) that is filled with 50 litre of developer (Fujifilm HD-P2).

Twenty sheets of LH-PSE, a thermal PS-plate available from Fujifilm totalling 16 m² are fed through this machine. About 50% of the total area is exposed by IR radiation. The machine is then shut down for 64 hrs, after which the machine is restarted by feeding another 10 sheets (8 m²). The plates do not show spots and, upon emptying it, the automatic development machine is free from any precipitate

### Example 5

An automatic development machine (Fujifilm FLH-85N) is filled with 50 litre of developer (Fujifilm HD-P2). To this bath, 60 cc of a 10% solution of Pionin D-1107, a polyoxyethylene alkyl ether available from Takemoto Oil and Fat Co., Ltd., is added. Twenty sheets of thermal PS-plate (Fujifilm LH-PSE), totalling 16 m² are fed through this machine. About 50% of the total area is exposed by IR radiation. The plates do not show spots, and, upon emptying it, the automatic development machine is free from any precipitate.

## Claims

1. A method for the development of lithographic printing plates in an automated development apparatus using an aqueous alkaline developer, wherein a surfactant is added to said developer during the preparation of the developer bath, or at the start of the usage of the developer.

2. Method according to claim 1, wherein said surfactant and said developer are present in said development apparatus in a substantially homogenous solution.

3. A method according to any of the previous claims, wherein the concentration of the surfactant in the final developer solution is from 0.005 to 2% by weight, preferably from 0.01 to 0.5% by weight.

4. A method according to any of the previous claims, wherein the surfactant is added to the developer before processing 0.2 square meter per litre developer.

5. A method according to any of the previous claims, wherein the surfactant is added to the developer before processing 0.02 square meter per litre developer.

6. A method according to any of the previous claims, wherein the surfactant is added to the developer before processing any plate.

7. A method as claimed in any of the previous claims, in which said surfactant is a hydrotrope.

8. A method as claimed in any of the previous claims, in which the surfactant is a salt of an alkyl sulfate, an (alkyl-)aryl sulfate, an alkyl sulfonate or an (alkyl-)aryl sulfonate.

9. A method as claimed in any of the previous claims, in which said surfactant is sodium-dodecyl-diphenylether-sulfonate.

10. A method according any of the previous claims, in which the surfactant is adsorbed on a filter.
